(19) Europäisches Patentamt
European Patent Office
Office européen des brevets

(11) **EP 1 889 258 B1**

(12) **EUROPEAN PATENT SPECIFICATION**

(45) Date of publication and mention
of the grant of the patent:
**01.03.2017 Bulletin 2017/09**

(51) Int Cl.:
*G10L 21/02* (2013.01)    *H03G 3/32* (2006.01)
*H03G 7/00* (2006.01)

(21) Application number: **06760069.2**

(22) Date of filing: **17.05.2006**

(86) International application number:
**PCT/US2006/019193**

(87) International publication number:
**WO 2006/125061 (23.11.2006 Gazette 2006/47)**

(54) **ADAPTED AUDIO RESPONSE**

ANGEPASSTE AUDIO-ANTWORT

REPONSE AUDIOFREQUENCE ADAPTEE

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **18.05.2005 US 131913**

(43) Date of publication of application:
**20.02.2008 Bulletin 2008/08**

(73) Proprietor: **Bose Corporation
Framingham, MA 01701-9168 (US)**

(72) Inventors:
• **GAUGER, Daniel, M., Jr.**
**Cambridge, MA 02139 (US)**
• **ICKLER, Christopher, B.**
**Sudbury, MA 01776 (US)**
• **HANAGAMI, Nathan**
**Cambridge, MA 02141 (US)**
• **JOHNSON, Edwin, C., Jr.**
**Hopkinton, MA 01748 (US)**

(74) Representative: **Attali, Pascal et al
Bose
12, rue de Témara
78100 Saint-Germain-en-Laye (FR)**

(56) References cited:
EP-A- 0 661 858        WO-A-00/19686
US-A- 4 494 074        US-A- 4 891 605
US-A- 5 208 866        US-A- 5 434 922
US-A- 5 666 426        US-A1- 2003 002 659

• **NATHAM FOX HANAGAMI: "Adding DSP
Enhancement to the BOSE Noise Caneling
Headphones" MATHER THESIS.
MASSACHUSETTS INSTITUTE OF
TECHNOLOGY, 18 May 2005 (2005-05-18),
XP008068310 USA**

EP 1 889 258 B1

## Description

### BACKGROUND

This invention relates to adaptation of an audio response based on noise or other interfering ambient signals.
When one listens to music, voice, or other audio over headphones, one is often seeking a private experience. Using the headphones presents the audio in a fashion that does not disturb others in one's vicinity and hopefully prevents sounds in one's environment (i.e., ambient noise such as conversation, background noise from airplanes or trains, etc.) from interfering with one's enjoyment of the audio.
Ambient noise can intrude on the quiet passages unless one listens to the audio at a sufficiently high volume, which may make subsequent loud passages uncomfortable or potentially dangerous. Using closed-back, noise-reducing, and especially active-noise-reducing (ANR) headphones can help by reducing the level of ambient noise at the ear. Even using such noise reduction, the available dynamic range between the maximum level one would like to hear and the residual ambient noise level after reduction by the headphone is often less than the inherent dynamic range of the input audio. This is particularly true with wide dynamic range symphonic music. One recourse is to repeatedly adjust the volume control in order to enjoy all passages of the music. Similarly, in situations in which one wishes to use the music as a background to cognitive activities, the user may adjust the volume so that the input music or other signal masks distractions present in the ambient noise while not intruding too much onto one's attention.
Approaches to adapting a speech signal for presentation in the presence of noise have made use of compression with the goal of achieving good intelligibility for the speech. Some such approaches compress the speech using a single compressor ratio, where said slope is computed from the available dynamic range determined from an estimate of the noise level and a maximum desired sound level (e.g., a loudness discomfort level).
US-A-5434922 discloses a system to compensate for the noise level inside a vehicle by measuring the music level and the noise level in the vehicle through the use of analog to digital conversion and adaptive digital filtering, including a sensing microphone in the vehicle cabin to measure both music and noise; preamplification and analog to digital (A/D) conversion of the microphone signal; A/D conversion of a stereo music signal; a pair of filters that use an adaptive algorithm such as the known Least Mean Squares ("LMS") method to extract the noise from the total cabin sound; an estimation of the masking effect of the noise on the music; an adaptive correction of the music loudness and, optionally, equalization to overcome the masking effect; digital to analog (D/A) conversion of the corrected music signal; and transmission of the corrected music signal to the audio system.
US-A-4891605 discloses an adaptive gain control amplifier described in relation to an audio system for adjusting output volume of a loudspeaker automatically in response to an interference signal such as background noise. The amplifier includes a divider circuit which computes the ratio of a time average of a corrupted signal which is a combination of a controlled output signal and the interference, to produce a control voltage which controls the gain of the amplifier. To reduce the dynamic range of the quotient of the ratio the divider circuit incorporates a logarithmic ratio circuit. The circuitry of the amplifier includes a "sensing channel" and a "reference channel" for extraction of the above averages of the corrupted signal and controlled output signal, respectively.
US-A-4494074 describes headphones having a small cavity between the diaphragm and the ear canal with a microphone in the cavity closely adjacent to the diaphragm providing a feedback signal that is combined with the input electrical signal to be reproduced by the headphones to provide a combined signal that is power amplified for driving the diaphragm.
WO-A-00/19686 describes dynamic compression of an audio signal for enhancing the subjective impression of this signal in the presence of noise: the compression of the dynamic of a signal in fact corresponds to a multiplication of each sample of this signal by a gain that depends on the amplitude of said sample. The proposed compression method is completely adaptive, because it comprises a step of selecting a compression law from various possible laws as a function of the measured noise. This selection step takes into account the level of the local noise and of the remote noise, that is, the noise contained in the received audio signal.

### SUMMARY

According to the present invention there is provided an audio processing system comprising:

> an input for receiving an audio signal;
> a microphone for monitoring an acoustic signal, the acoustic signal including components of an interfering signal and the audio signal;
> a compressor circuit for compressing the audio signal at a first compression ratio when the audio signal is at a first level determined from the monitored acoustic signal and compressing the audio signal at a second compression ratio when the audio signal is above a second level determined from the monitored acoustic signal, the first level being lower than the second level and the first compression ratio being at least three times greater than the second compression ratio; and

a tracking circuit configured to produce an estimate (SNSR, 321) of a ratio of a level of the audio signal to a level of the acoustic signal; and wherein the compressor circuit is arranged to calculate the compression ratios from said estimate produced by the tracking circuit, thereby avoiding separating the components of the audio signal and the interfering signal.

The compressor circuit may be configured to reduce a masking effect related to the interfering signal.

Reducing the masking effect related to the interfering signal comprises at least one of reducing an intelligibility of the interfering signal, reducing a distraction by the interfering signal, and masking the interfering signal.

The second level may be greater than the first level.

The audio processing system may comprise a masking module that receives the audio signal and the acoustic signal, the masking module including circuitry for processing the audio signal according to a level of the acoustic signal, including controlling a level of the audio signal input to reduce a masking effect of an interfering signal present in the acoustic signal.

The audio processing system may also comprise a selector to selectively enable at least one of the compression circuit and the masking module.

The audio processing system may also comprise a first input for receiving an audio signal;

a second input for receiving a microphone signal that includes components related to the audio signal and an interfering signal; a correlator for processing the audio signal according to a level of the microphone signal and a level of a modified audio signal, a level of the modified audio signal being controlled to reduce a distracting effect of the interfering signal; a bandpass filter that filters the microphone signal; and a bandpass filter that filters the modified audio signal.

The audio processing system may also comprise a control circuit that controls the level of the modified audio signal.

The control circuit preferably controls the level of the modified audio signal such that an output of the correlator is substantially equal to or greater than a threshold value.

The control circuit may comprise an integrator, an output of the integrator being responsive to an output of the correlator and an output of a user controllable correlation target.

The audio processing system may further comprise an earpiece, headphone or headset comprising a driver, wherein at least one of the tracking circuit and the compressor circuit is at least partially contained within the earpiece, headphone or headset.

Embodiments can have one or more of the following advantages.

Estimation of the noise level in the absence of audio does not necessarily have to be computed allowing adaptation of the audio signal based on measures of the audio level as well as level of the audio plus residual ambient noise under the earpiece For example, direct determination of the gain and/or compression ratio to be applied based on a SNSR value (ratio of signal to noise plus signal) measured in an earpiece of a headphone is enabled. This can avoid a relatively computationally expensive signal processing, which is desirable a portable, battery-powered system.

Determination of the gain from the SNSR by comparing the audio signal input to the total signal (reproduced audio plus residual noise) at a microphone under the earpiece can offer several advantages. As a result of the relationship between SNR and SNSR, a two-segment piecewise linear relationship describing gain as a function of SNSR results in a smooth transition from uncompressed to highly compressed audio.

A user is able to choose whether he or she would like to experience that music in the presence of noise in one of two different manners. One manner, termed "upward compression," has the goal of allowing the full dynamic range of the music to be heard by the user in the presence of noise while preserving the inherent dynamic qualities of the music. Rather than applying a simple compression of the audio, which could affect the dynamic qualities of relatively loud passages, the audio that is quiet enough to be masked by the noise is adapted, but when the music signal is substantially louder than the noise, substantially no compression is applied thereby preserving the dynamic qualities. The other manner, termed "auto-masking," has the goal of using the audio to prevent the user being distracted by aspects of the noise, primarily conversations of nearby people.

Other features and advantages of the invention are apparent from the following description, and from the claims.

DESCRIPTION OF DRAWINGS

FIG. 1 is an overall block diagram of a headphone audio system.

FIG. 2A is a graph relating an audio signal input level and an output audio level.

FIG. 2B is a graph of compression module gain versus signal-to-(noise+signal) ratio (SNSR).

FIG. 2C is a graph relating the signal-to-noise ratio (SNR) to the SNSR.

FIG. 3 is a block diagram of a compression module.

FIG. 4 is a block diagram of a masking module

FIG. 5 is a block diagram of a noise reduction module.

## DESCRIPTION

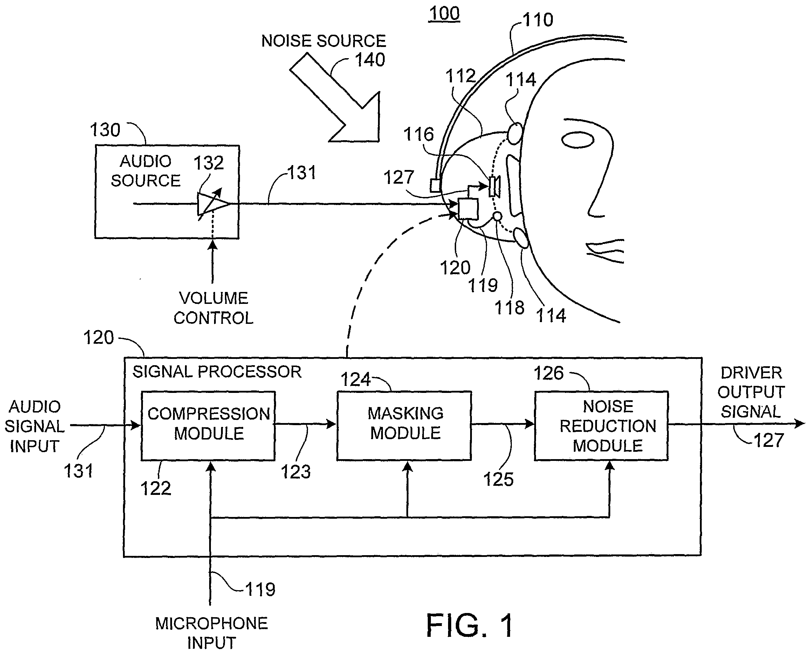

### 1. System Overview (FIG. 1)

Referring to FIG. 1, an audio system 100 includes a headphone unit 110 worn by a user. The headphone unit receives an audio signal input 131 from an audio source 130. The audio source 130 includes a volume control 132 that can be adjusted by the user. The user listens to an acoustic realization of the audio signal input that is generated within the earpiece.

In general, a noise source 140, such as a source of mechanical noise, people conversing in the background, etc., generates ambient acoustic noise. The ambient acoustic noise is attenuated by the physical design of the headphone unit 110 (e.g., through the design of earpiece 112 and ear pad 114) and optionally using an active noise reduction system embedded in the headphone unit. The audio signal input 131 is processed in the headphone unit in a signal processor 120 and a driver output signal 127 is passed from the signal processor 120 to a driver 116, which produces the acoustic realization of the audio signal input. The user perceives this acoustic realization in the presence of an interfering signal, specifically in the presence of the attenuated ambient noise. The signal processor may alternatively be located external to earpiece 112.

A number of transformations of the audio signal input 131 that are performed by the signal processor 120 are based on psychoacoustic principles. These principles include masking effects, such as masking of a desired audio signal by residual ambient noise or masking of residual ambient noise by an audio signal that is being presented through the headphones. Another principle relates to a degree of intelligibility of speech, such as distracting conversation, that is presented in conjunction with a desired signal, such as an audio signal being presented through the headphones. In various configurations and parameter settings, the headphone unit adjusts the audio level and/or compression of a desired audio signal to mitigate the effect of masking by ambient noise and/or adjusts the level of a desired signal to mask ambient noise or to make ambient conversation less distracting. In some versions, the user can select between a number of different settings, for example, to choose between a mode in which the headphones mitigate ambient noise and a mode that makes ambient conversation less distracting.

The signal processor 120 makes use of an input from a microphone 118 that monitors the sound (e.g., sound pressure level) inside the earpiece that is actually presented to the user's ear. This microphone input therefore includes components of both the acoustic realization of the audio signal input and the attenuated (or residual) ambient noise.

The signal processor 120 performs a series of transformations on the audio signal input 131. A compression module 122 performs a level compression based on the noise level so that quiet audio passages are better perceived by the user. A masking module 124 performs gain control and/or level compression based on the noise level so the ambient noise is less easily perceived by the user. A noise reduction module performs an active noise reduction based on a monitored sound level inside the earpiece. In alternative versions of the system, only a subset of these modules is used and/or is selectively enabled or disabled by the user.

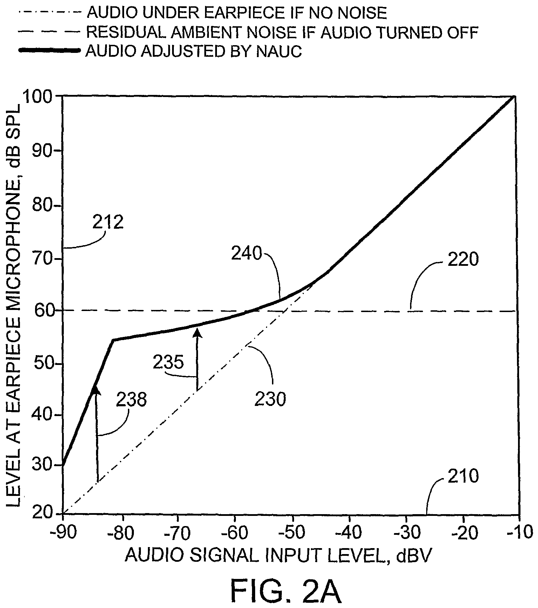

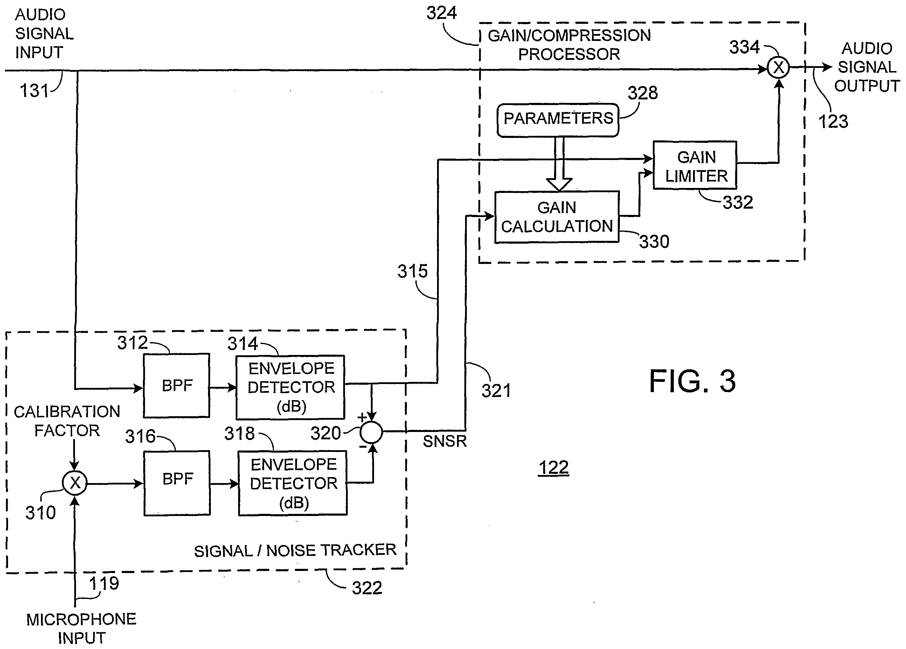

### 2 Upward compression (FIGS. 2A-C, 3)

For some modes of operation and/or parameter settings, the compression module 122 provides level compression based on the noise level so that quiet passages are better perceived by the user. The general approach implemented by the compression module 122 is to present portions of the audio signal input that are louder than the ambient noise with little if any modification while boosting quiet portions of the audio signal input that would be adversely affected by the ambient noise. This type of approach is generally referred to below as "Noise Adapted Upward Compression (NAUC)." The result is a compression of the overall dynamic range of the input audio signal, where the net amount of compression applied is a function both of the dynamic range of the input audio and the relative level that the user wishes to listen to compared to the ambient noise level the user hears.

NAUC is designed to account for masking caused by residual ambient noise inside the earpiece. If this noise is loud enough relative to an audio signal input, the noise can render the audio signal inaudible. This effect is known as complete masking in the psycho-acoustic literature. The signal-to-noise ratio (SNR) at which complete masking occurs is a function of various factors, including the signal and noise spectra; a typical value is approximately -15dB (i.e., the audio signal is 15dB quieter than the residual ambient noise). If the signal-to-noise ratio is greater than that needed for complete masking then partial masking is said to occur. Under conditions of partial masking, the perceived loudness of the signal is reduced compared to when the masking noise is absent. In the range between complete masking and no masking, the steepness of the loudness function increases as compared to a noise-free condition (i.e., a larger apparent change in signal loudness is heard for a given change in objective signal level). When listening to audio in the presence of residual ambient noise, a user can set the volume control for the desired level of the loudest passages of the music and the NAUC processing applies a compression of the audio appropriate to the volume setting. The NAUC approach provides audibility, and reasonably natural perception of the dynamics of the quieter passages in the presence of the noise.

To illustrate the masking effect quantitatively, assume that the earpiece unit provides 20dB of noise reduction of ambient noise outside the headphones. For example, while riding in an airliner with 80dB SPL (Sound Pressure Level) interior noise level, the attenuated ambient noise at the ear is 80dB minus 20dB or 60dB SPL. Assume that the user is listening to symphonic music with a 60dB dynamic range and adjusts the volume control of the audio source so that the crescendos are presented at the rather loud level of 95dB SPL. The quietest passages of the music will be at 95dB minus 60dB or 35dB SPL. However, the attenuated ambient noise in this example is at 60dB SPL, and therefore the quietest passages are at an SNR of -25dB, which is more than the typical threshold for complete masking, so these quiet passages will be completely masked. In the NAUC approach, these quiet passages are amplified (upward compressing them) while not substantially changing the dynamics of the louder passages.

Referring to FIG. 2A, an example of a relationship between the level of the audio signal input (X-axis 210) and the level of the output acoustic realization of the audio signal (Y-axis 212) for a particular level of ambient noise in the earpiece. The dashed line 220 represents the residual ambient noise level (60dB SPL) in the earpiece. Note that this ambient noise level is independent of the audio signal input level. The output audio level that would result in the earpiece as a function of the input signal, if it were used in an environment with no ambient noise, is shown by the dash-dot line 230. This input-output relationship is linear (e.g., a 20dB input level change causes a 20dB output level change) and reflects an uncompressed gain for the headphone itself of 110dB from the input (in dBV) to the output (in dB SPL).

In FIG. 2A, the solid curve 240 shows how the compression module 122 that is configured to implement NAUC modifies the acoustic realization level at the ear due to the audio input. For input signals such that the uncompressed audio output level at the ear would be well below the residual noise level (less than -80dBV input as shown) the signal processor provides a compressor module gain 235 that is as large as 25dB.

With moderate residual noise under the headphone earpiece, if the user listens to audio that is substantially louder than the residual noise, the audio is not appreciably modified by NAUC (this corresponds to the input signals above -45dBV in FIG. 2A). If the user subsequently turns the volume down so that the quieter portions of the music approach or are less than the noise level, the compression module responds by amplifying those passages. The lower the audio signal input level relative to the residual noise level, the more gain 235 is provided by the compression module, until very low audio levels are reached (less than -80dBV input as shown).

The gain characteristics of the NAUC compression module as illustrated in FIG. 2A is not characterized by a single compression ratio. If the user listens to music with a limited dynamic range at a loud level relative to the residual noise, the NAUC compression module reproduces the music without compression. As the audio volume setting is decreased, the dynamic range is increasingly compressed. If the parameters determining the shape of line 240 are suitably chosen, the increasing compression with decreasing level compensates for the effects of partial masking of the audio by the noise. The result for the user is that the inherent dynamic qualities of the music, in the presence of the residual noise and processed by the NAUC system, sound largely the same as when the music is listened to in the absence of noise and without compression.

For input signals such that the uncompressed audio output level at the ear would be well below the residual noise level, the compression module can continue to provide increasing gain or, as shown for levels less than -80dBV in FIG. 2A, can preferably provide a downward expansion characteristic. In such a range, gain 238 decreases with decreasing input level. Downward expansion can be useful by ensuring that the self-noise floor of the audio source is not amplified to the point that it becomes audible and objectionable.

Referring to FIG. 3, the compression module 122 of the signal processor 120 includes a signal/noise tracker 322, which processes the audio signal input 131 and the microphone input 119 to determine estimates related to the audio signal input level and monitored audio microphone level. In the present embodiment the monitoring microphone is located inside an earpiece of the headphone; therefore the microphone output includes components comprising the audio signal and residual ambient noise at the user's ear. Note that if the headphones include a noise reduction module 126, for example for active noise reduction (ANR), one microphone 118 can be used for both ANR and NAUC signal processing. The input is processed through a gain/compression processor 324 that applies gain and/or level compression based on control information provided from the signal/noise tracker 322.

The signal/noise tracker 322 accepts the audio signal input 131 and the microphone input 119. The microphone input 119 is applied to a multiplier 310 that multiplies the input by a calibration factor to adjust the relative sensitivity of the headphone system, and to make the microphone input after calibration and the audio signal input essentially equal in level for typical audio signals in the absence of any substantial ambient noise. The two signals, the audio signal input 131 and the calibrated microphone input, are then passed through band-pass filters (BPF) 312 and 316, respectively, to limit the spectrum of each to a desired range. In the present embodiment, the BPF blocks, pass frequencies from 80 to 800 Hz. This bandwidth is chosen because the response of a typical ANR headphone, from audio input to acoustic output in the earpiece, varies less from wearer to wearer within this range of frequencies compared to other bandwidths. This frequency range also encompasses most of the energy in typical audio signals. Other BPF bandwidths could alternatively be used.

The signals from BPF blocks 312 and 316 are of limited bandwidth and can be decimated or resampled to a lower sample rate in digital signal processing embodiments. This allows the processing for blocks 314 and 318 and all elements in gain/compression processor 324 except multiplier 334 to be done at the decimated rate, reducing computation and power consumption. In the present embodiment, the outputs of the BPF blocks are decimated to a 2.4kHz sample rate. Other rates, including full audio bandwidth may be used as well.

The outputs of the BPF blocks 312 and 316 are fed into envelope detector 314 and 318, respectively. The function of each envelope detector is to output a measure of the time-varying level of its input signal. Each envelope detector squares its input signal, time averages the squared signal, and then applies a logarithm ($10*\log_{10}()$) function to convert the averaged level to decibels. The two envelope detectors have different averaging time constants for rising and falling signal levels. In the present embodiment, the envelope detector has a risetime of approximately 10 milliseconds and a falltime (release time) of approximately 5 seconds; other rise and fall time constants, including equal values for risetime and falltime, can alternatively be used. A rapid rise / slow fall envelope detector is a common characteristic of audio dynamic range compressors, with the choice of time constants being an can be important aspect of minimizing to minimize audible "pumping" of output signal levels in response to changing dynamics of the input. In the present system, referring to FIG. 2A, a fast risetime ensures that, when the audio signal input level increases rapidly from the partial or complete masking region (SNR < 0dB) to the no masking region (SNR > 0dB) the compressor module gain 235 is rapidly reduced so the audio does not sound abnormally loud.

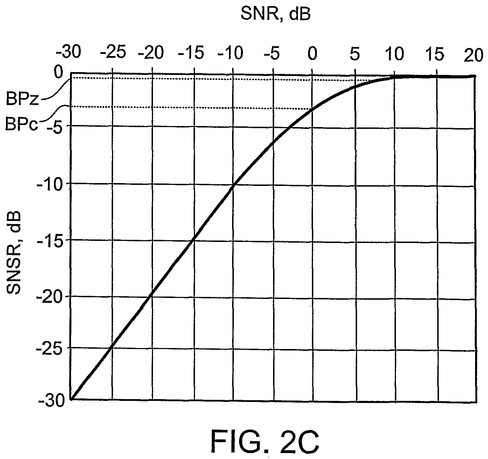

The outputs (in dB) of the envelope detectors 314 and 318 are subtracted at a difference element 320, audio envelope minus microphone envelope, to produce an estimate of the audio signal-to-(noise+signal) ratio (SNSR) 321 present in the earpiece. If the calibration factor input to multiplier 310 is properly set and with the headphone operating on the head in a quiet environment (i.e., negligible residual ambient noise) then typical audio signals should result in equal envelope detector outputs, corresponding to an SNSR of 0dB. Referring to FIG. 2C, a graph of the SNSR (Y-axis) as a function of the SNR (X-axis) shows that in the presence of residual ambient noise, for low audio levels (SNR < 0dB) the SNSR approximates the SNR whereas for high audio levels (SNR > 0dB) the SNSR approaches a maximum value of 0dB; for an SNR = 0dB (equal levels for the residual ambient noise and the acoustic realization of the audio signal) then SNSR = -3dB. The relationship between SNSR and SNR (in dB) shown in FIG. 2C can be expressed mathematically (assuming no correlation between the audio and noise) as:

$$\text{SNSR} \quad = \quad 10\log_{10}\left(\frac{10^{\text{SNR}/10}}{1+10^{\text{SNR}/10}}\right)$$

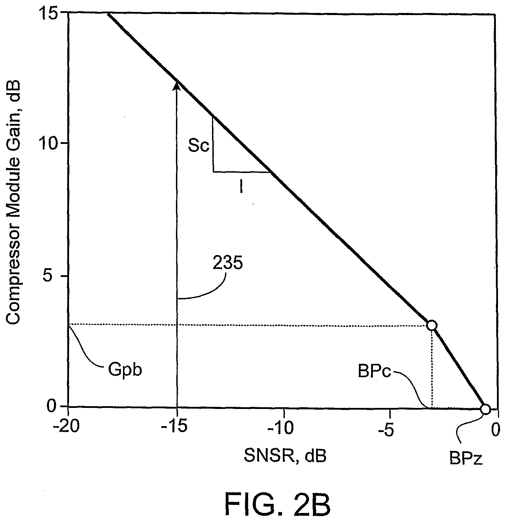

Referring again to FIG. 3, the SNSR and the output of the audio envelope detector 314 are passed to the gain/compression processor 324 to determine the amount of gain to apply to the audio signal. The gain/compression processor 324 applies a time-varying gain to the audio that is determined from the SNSR in a gain calculation block 330. Referring to FIG. 2B, compressor gain 235 as a function of SNSR 321 corresponds to the graph shown in FIG. 2A. This gain is specified according to a set of four parameters 328. Specifically, in the present embodiment the gain is calculated according to four parameters (BPz, BPc, Gbp, and Sc) with different formulas being applied in three ranges of SNSR as follows.

For a range of SNSR > BPz, the gain is 0dB. In the example shown in FIG. 2B, the breakpoint BPz = -0.5dB. A SNSR of -0.5dB corresponds to an SNR of approximately 10dB (i.e., the signal level is well above the noise masking level), as indicated in FIG. 2C.

For SNSR = BPc (where BPc < BPz), the gain applied is Gbp. For a range SNSR < BPc, a compression slope of Sc on the gain as a function of SNSR is applied to the input level. That is, for every 1dB decrease in SNSR, the gain increases by Sc dB. For audio levels well below the residual noise level (e.g., less than -10dB SNR), SNSR approximates quite closely the SNR, as shown in FIG. 2C. The dependence of gain on SNSR thus results in a compression ratio of 1:(1-Sc). In the example in FIGS. 2B-C, the BPc breakpoint is chosen to be at SNSR = -3dB, which corresponds to an SNR of approximately 0dB; this occurs at an input level of -50dBV in the FIG. 2A. In the example of FIGS. 2A-B over a range of input levels the compression slope Sc is chosen to be 0.8 which corresponds to a compression ratio of approximately 1:0.2, or 5:1. Over the input range of -60dBV (corresponding to -10dB SNR) down to -80dBV FIG. 2A shows an approximately linear increase in compressor module gain 235 as the input level decreases.

In the intermediate region BPc < SNSR < BPz, the gain is linearly interpolated (as a function of SNSR) between a gain of 0 at SNSR = BPz to gain of Gbp at SNSR = BPc as shown in FIG. 2B. In the example, Gbp = 3dB. The range of BPc < SNSR < BPz corresponds to a range of audio signal input level of approximately 10dB, which results in a range of output level of 10dB-3dB = 7dB, appreciably less than the 5:1 compression applied to lower audio signal input levels.

The gain calculation incorporating these parameters, implemented in 330 and outlined above, can be expressed succinctly as follows:

$$
G(\text{dB}) = \begin{cases} 0 & SNSR > BPz \\ Gbp * \left(1 - \dfrac{(SNSR - BPc)}{(BPz - BPc)}\right) & BPc < SNSR < BPz \\ Gbp + (BPc - SNSR) * Sc & SNSR < BPc \end{cases}
$$

The equation above describes the compression module gain 235 for audio inputs corresponding to SNSR < BPz in terms of two segments, each of which are linear on SNSR and which join at SNSR = BPc, as well as the segment of zero gain for SNSR > BPz. Given the nature of the relationship between SNSR and SNR, as illustrated in FIG. 2C, over the range -10dB < SNR < 10dB, the piecewise linear relationship between gain and SNSR (shown in FIG. 2B) results in a compressor gain 235 applied to the audio input that smoothly transitions from the high compression region (slope Sc, SNSR < -10dB) to decrease toward zero compressor gain (slope 1, SNSR > 10dB), as shown in FIG. 2A. The effective compression that results in this region is not characterized by a single slope as it is when SNSR < BPc.

The four parameters (BPz, BPc, Gbp and Sc) may be chosen based on the psychoacoustic experiments on partial masking but preferably are set based on comparative listening to music both in the absence and presence of noise. Chosen properly, these parameters ensure that the inherent dynamic qualities of music are similar when it is listened to over the headphones either in quiet or in the presence of residual ambient noise. Other values than those presented in the example above may be desirable. At least some choices of the parameters provide approximate restoration of musical dynamics in the presence of noise and, in particular, the smooth transition from uncompressed audio for large signals (much greater than 0dB SNR) to highly compressed audio for small signals (less than 0dB SNR). Listening tests have shown that compression ratios for small signals in excess of 3:1 and compression ratios for large signals substantially less than 2:1 (preferably 1:1) are desirable.

The output of the gain calculation block 330 is fed to a gain limiter 332 that limits that gain so that the gain is not excessive for very low audio signal input levels. An effect of this gain limiter is to ensure that the gain is reduced so that when the audio signal is low or possibly absent (e.g., the audio source is turned on but not playing or during the silence between musical tracks) the self-noise floor of the source itself is not amplified to undesirable levels. In the example shown in FIG. 2A, the gain limiter is determined by first computing a downward expansion gain value equal to the expansion slope times the difference, in dB, between the audio signal input level and a zero reference level. The zero reference level corresponds to the audio signal input level with no signal playing and for which no compression module gain is to be applied. The actual gain in dB to apply to the audio signal is the minimum of the gain determined by gain calculation 330 and this downward expansion gain.

In the example in FIG. 2A, the downward expansion slope is 2:1 and the zero reference level is -95dBV. These values, along with the 60dB SPL residual noise level shown in FIG. 2A, allow a maximum compressor module gain of approximately 25dB (at audio signal input level of -80dBV). As the residual noise level is reduced, the point at which the high compression part of curve 240 intersects with the downward expansion portion will slide to the left on the figure and the maximum gain provided by the compression module will decrease. If the zero reference level and expansion slope are properly chosen, based on listening experiments and the actual hardware's self-noise characteristics, the audibility of audio source or signal processor self-noise is minimized. Other means of limiting gain for low audio signal input levels may also be used while achieving the basic qualities of the NAUC system.

In addition, gain limiter 332 incorporates gain slew rate limiting. It is presumed that the residual ambient noise is in most cases nearly constant or slowly varying; it is undesirable to have the NAUC system suddenly amplify the audio in response to transient noises in one's environment such as results from accidentally tapping the earpiece or coughing. To minimize this, the gain limiter in the present embodiment limits the rate at which gain can increase to a rate of 20dB/second. No limit on the rate at which gain can decrease is applied so that the system reacts as determined by gain calculation 330 to rapid increases in the audio signal input level.

The output of the gain limiter 332 is then converted from decibels to a scale factor, passed through an anti-zipper-noise filter (to eliminate the audible effect of discrete gain steps and then applied at a multiplier 334 to amplify the audio signal input 131 producing an audio signal output 123 that is passed to the masking module 124.

A characteristic of the system is the absence of a requirement to estimate the noise level in the absence of audio. The gain is determined from the SNSR (ratio of signal to noise plus signal) rather than the SNR (ratio of signal to noise).

2.1 Alternatives

Alternatively, a microphone external to the headphone's earpiece(s) can be used to determine the noise level. The signal level is adjusted for the noise attenuation of the earpiece (passive and possibly ANR) and the sensitivity of the headphone itself (gain from audio signal input level to sound pressure level under the earpiece). Note that the combined uncertainty in these factors can be significant, which may result in a less accurate compensation of the effects of partial masking by the compressor module. However, there may be situations (e.g., in the case of open-back headphones that provide little if any noise attenuation) in which placement of the microphone outside the earpiece outweighs such potential uncertainty.

An SNSR based and under-earpiece-microphone based compressor module, as described above, may also be sensitive to how accurately the headphone and microphone sensitivity is known. An addition optional block can be added to the block diagram of FIG. 3 to enable the system to self-calibrate. This block would take as inputs SNSR 321 and audio signal input envelope 315 and output the calibration factor applied to multiplier 310. This optional block adjusts the calibration factor slowly to ensure that, when the audio signal input envelope is large the SNSR is 0dB. Preferably the calibration factor is only updated to achieve 0dB SNSR during intervals with large audio signal input envelope levels when said intervals follow a short time after intervals where the audio level is substantially lower while, at the same time, SNSR was moderate (in the vicinity of 0dB SNR). Assuming that the noise level is slowly changing, this ensures that the calibration factor update only occurs when the audio level significantly exceeds the residual noise level.

BPFs 312 and 316 may be designed so as to pass a range of frequencies other than the 80 to 800 Hz range of the present embodiment. Alternately, other filter characteristics than a band-pass response may be used to select the portion of the audio input and monitored microphone signals from which the levels are determined.

Other implementations of the envelope detectors 314 and 318 can be used. For example, the envelope detectors can operate on absolute values (i.e., signal magnitude) rather than squared values. This reduces the computational burden and computational dynamic range challenges in fixed-point DSP implementations. Also, logarithms in bases other than base 10, other scale factors than 10 or 20 applied to the logarithm, or other nonlinear functions may be alternatively used to describe signal levels instead of decibels. For example, truncated Taylor series expansions may be used instead of the logarithm or power functions ($10^x$) used in converting to and from the level units; these can be computed over various ranges of values using coefficients from a lookup table that have been pre-computed. This approach can be sufficiently accurate while computationally more efficient than the logarithm or power function in a fixed-point DSP implementation.

Other envelope detection time constants than those described above can be used. For example, equal values could be used such as are used in speech envelope detectors (typically, 10 milliseconds). Alternatively, slower time constants can be used resulting in more of an automatic volume adjustment rather than compression characteristic in response to the residual noise level. Another alternative is for the envelope detectors to average by means of slew rate limits, either symmetric or asymmetric on the rise and fall, rather than by means of rise and fall time constants created by a filter with a feedback topology.

The signal processing blocks shown in FIG. 3 can be implemented in discrete time to occur at the sample rate required for full audio bandwidth without any decimation after BPF blocks 312 and 316.

It is also desirable to have the microphone envelope detector 318 reject sudden transients such as are caused by tapping an earpiece; the present embodiment incorporates gain slew rate limiting into gain limiter 332 for this purpose. Rather than using identical time constants for audio and microphone envelope detectors 314 and 318, different time constants may also help mitigate the effect of transient noises. The time constants used in the microphone level detect 318 could also be made to vary as a function of the outputs of the audio and microphone level detectors 314 and 318. For example, the microphone level detector could be set to slowly respond to changes except when a rapid rate of change of the audio level is observed. Alternatively, more sophisticated transient rejection can also be employed in the gain limiter function such as using the median or mode (most common value) of the level within a moving window. Such alternate approaches can include variants of the median or mode that respond differently to sudden increasing or decreasing gain transients. To be most effective such gain limiting filters are non-causal, requiring the audio signal input to be delayed an appropriate amount prior to multiplier 334.

A simpler gain calculation 330 may be achieved by setting the compressor gain, in dB, equal to a constant times the negative of the SNSR. If the constant is Sc (G = -SNSR*Sc) then the resulting gain is very similar to that shown in FIG.2A, with a maximum difference from the more complex, four parameter gain calculation described above of only 0.6dB for Sc = 0.8. Of course, the error using such a simplified gain calculation would be larger for different Gbp, Sc, BPc, and BPz values. This simpler gain calculation provides only one parameter determining the compression slope for SNSR << 0dB. However, no other parameters are available to allow fine tuning the operation of the compression module in listening tests.

Alternatively, and though it could require additional computational complexity, the gain calculation 330 as a function of SNSR could use additional breakpoints or alternative gain calculation arithmetic. The parameters used in the envelope detection and gain calculation could also be made to vary with audio or microphone level.

Alternatively, the upward compression could be done separately in different frequency bands, so as to better approximate the psycho-acoustic characteristics of partial masking at various levels or to mitigate the amplification into audibility of the audio source self-noise floor. If the upward compression is done in a multi-band fashion, it could be desirable to have noise levels from lower frequency bands factor into the compression calculation at higher frequencies so as to approximately compensate for the psycho-acoustic effect of upward spread of masking. This could be done by (a) factoring in a fraction of the lower frequency SNSR or microphone level values in determining the effective SNSR value in higher frequency bands used to compute compressor gain or (b) by making the bandpass filter prior to the microphone level estimate block have a less-steep lower frequency slope than the BPF prior to the audio envelope detector block, thereby including some lower frequency noise energy in the SNSR determination for that frequency band.

It can also be desirable to have the system modify the upward compression characteristic during intervals when no audio signal is present so that audio source or input circuitry self-noise is not amplified, becoming objectionable; the present embodiment includes an input audio level dependent downward expansion in gain limiter 332 to achieve this. Multi-band operation can also achieve this. Other approaches to achieve a lowering of gain during intervals of very low audio input level may also be used, such as adjusting the upward compression gain calculation parameters (e.g., Gbp and Sc) as a function of input audio level, microphone level or SNSR.

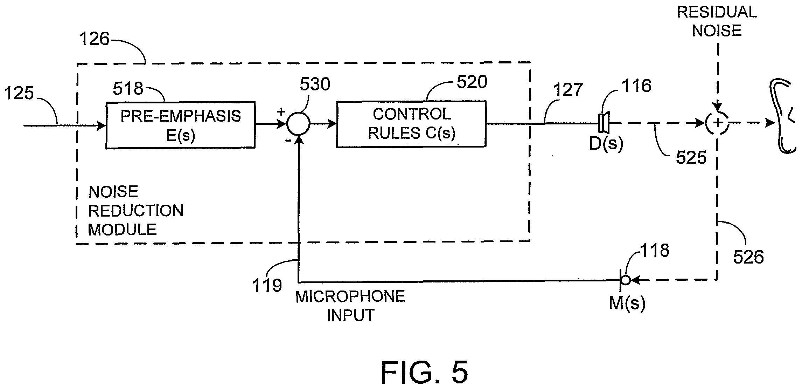

Though reasons are given above stating why an SNSR-based compression determination is advantageous, similar input-to-output characteristics as that represented by line 240 in FIG. 2A can be achieved if an SNR estimate is available. An estimate of the noise level could be determined from the microphone level during intervals when the SNSR is less than -10dB or a comparable threshold; this value could be held fixed in a memory register during intervals when SNSR is greater than the threshold. The stored noise level estimate could then be used to determine an SNR value as an input to a different gain computation. More sophisticated and computationally intensive parameter estimation or adaptive filter techniques could be applied to estimate the residual noise under the headphone earpiece, absent the headphone audio, as well. Also, signals derived within the noise reduction module can be used instead of the raw microphone input 119. For example, the difference between the microphone input and the desired audio signal at the differencing element 530 (see FIG. 5) can be used. Alternatively, a microphone external rather than internal to the earpiece could be used to directly measure the noise and then some calibration (representing the headphone's noise attenuation) applied to estimate the residual noise under the earpiece. Given an SNR value obtained using any of the above methods, the desired gain, including the uncompressed characteristic for SNR >> 0dB and highly compressed characteristic for SNR << 0dB, can be computed from a piecewise linear or polynomial function.

Compression of high-level audio signals could be added to ensure that the headphone does not produce painfully loud, hearing damaging, or distorted audio levels.

The parameters determining the upward compression as a function of SNSR or SNR can be made user-adjustable, while maintaining the uncompressed characteristic for SNR >> 0dB.

The embodiment described above implements NAUC in a headphone. Noise adaptive upward compression can alternatively be applied in other situations, for example in situations characterized by an approximately known time delay for propagation of output audio signal 123, through an acoustic environment, to microphone signal 119 and that said acoustic environment is largely absent of reverberation. In such conditions continuous constant-level noise and for SNR << 0dB provides good correlation between the input audio envelope (adjusted by the aforementioned delay) and the SNSR so that an appropriate gain to achieve high compression of the audio input can be determined from the SNSR. Examples of environments in which NAUC may be advantageously applied include telephone receivers, automobiles, aircraft cockpits, hearing aids, and small limited-reverberation rooms.

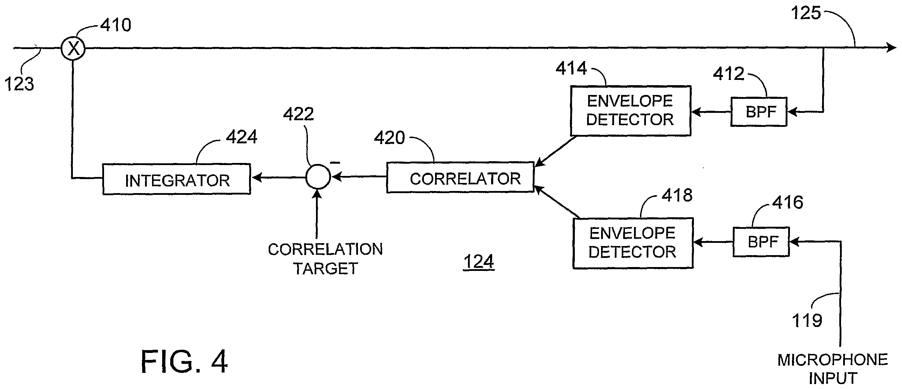

### 3 Auto-Masking (FIG. 4)

The masking module 124 automatically adjusts the audio level to reduce or eliminate distraction or other interference to the user from signal the residual ambient noise in the earpiece. Such distraction is most commonly caused by the conversation of nearby people, though other sounds can also distract the user, for example while the user is performing a cognitive task.

One approach to reducing or eliminating the distraction is to adjust the audio level to be sufficiently loud to completely mask the residual ambient noise at all times. The masking module 124 achieves a reduction or elimination of the distraction without requiring as loud a level. Generally, the masking module 124 automatically determines an audio level to provide partial masking of the residual noise that is sufficient to prevent the noise (e.g., conversation) from intruding on the user's attention. This approach to removing distraction can be effective if the user has selected audio to listen to which is inherently less distracting and to the user's liking for the task at hand. Examples of such selected audio can be a steady noise (such as the masking noise sometimes used to obscure conversation in open-plan offices), pleasant natural sounds (such as recordings of a rainstorm or the sounds near a forest stream), or quiet instrumental music.

A simple quantitative example can illustrate how beneficial this type of masking approach can be. Suppose the user is working in an open-plan office with a background noise level of 60dB SPL resulting from the conversation of one's neighbors. If a headphone that provides 20dB noise reduction is donned, the resulting residual noise level of the distracting conversation at the ear is 60dB minus 20dB, or 40dB SPL. Although attenuated, this residual noise level can be loud enough for a person with normal hearing to easily understand words and thus potentially be distracted. However, assuming that an SNR of -10 dB (i.e., the ratio of residual unattenuated conversation "signal" level to audio input masking "noise" level) provides sufficient partial masking so as to make the surrounding conversation unintelligible (or at least not attention grabbing), then the user can listen to audio of the user's choice at a level of 50dB SPL and obscure the distracting conversation. Thus, when wearing such a system the user is immersed in 50dB SPL audio that the user prefers to work by, as opposed to the 60dB SPL (i.e., 10 dB louder) background conversation that may have distracted the user.

The masking module 124 adjusts the level of the audio signal input so that it is only as loud as needed to mask the residual noise. Generally, in the example above, if the ambient noise level was 55dB rather than 60dB SPL, then the audio signal would be presented to the user at a level of 45dB rather than 50dB SPL.

The masking module 124 adjusts a gain applied to a signal multiplier 410 in a feedback arrangement based on the resulting microphone input 119. In general, the amount of gain determined by the module is based on the psychoacoustic principles that aim to relate the degree of intelligibility of speech signals in the face of interfering signals such as noise and reverberation. One objective predictor of such intelligibility is the Speech Transmission Index, which is an estimate of intelligibility based on a degree to which the modulations of energy in speech (i.e., the energy envelope) is preserved between a desired signal and the signal presented to the user. Such an index can be computed separately at different frequencies or across a wide frequency band.

Referring to FIG. 4, the masking module 124 determines energy envelopes associated with each of the microphone input 119 and the audio signal 125 after the gain adjustment (at multiplier 410). The masking module 124 determines the amount of gain to apply based on the relationship between these energy envelopes. The gain is adjusted in a feedback arrangement to maintain a desired relationship between the energy envelopes.

The audio signal 125 and the microphone input 119 are passed to band-pass filters 412 and 416, respectively. The pass bands of these filters are 1kHz-3kHz, which is a band within which speech energy contributes significantly to intelligibility. The filtered audio signal and microphone input are passed to envelope detectors 414 and 418, respectively. The envelope detectors perform a short-time averaging of the signal energy (i.e., squared amplitude) over a time constant of approximately 10ms, which captures speech modulations at rates of up to approximately 15Hz.

The outputs of the two envelope detectors 414 and 418 are input to a correlator 420, which provides an output based on a past block length, which in this version of the system is chosen to be of duration 200ms. The correlator normalizes the two inputs to have the same average level over the block length then computes the sum of the product of those recent normalized envelope values. In general, if the correlation is high, then the microphone input largely results from the audio input, which means there is relatively little residual noise (distracting conversation) present. If the correlation is low, the microphone input largely results from the residual noise and the input audio is not loud enough to obscure it.

The output of the correlator 420 is subtracted at an adder 422 from a correlation target value. This value is set based on a value determined experimentally to provide sufficient masking of distracting speech. A typical value for the correlation target is 0.7. Optionally, the user can adjust the correlation target value based on the user's preference, the specific nature of the ambient noise, etc.

The output of the adder 422 is passed to an integrator 424. The integrator responds to a constant difference between the measured correlation and the target with a steadily increasing (or decreasing, depending on the sign of the difference) gain command. The gain command output of the integrator 424 is applied to a multiplier 410, which adjusts the gain of the audio signal input. The integrator time constant is chosen to establish a subjectively preferred rate at which the audio gain controlling feedback loop shown in FIG. 4 responds to changes in distracting conversation level. A response time of five to ten seconds is appropriate. Alternative responses may be used in place of integrator 424. For example, a low-pass filter with high gain at DC may be used to regulate the output of correlator 420 to be sufficiently close to the target value as to achieve the desired level of masking.

### 3.1 Alternatives

To prevent dynamics in music used as masking audio from intruding too much into one's attention (e.g., when it is desired for the music to remain a pleasant background to cognitive tasks) it may be desirable to compress input audio 123 prior to the level adjustment provided by the masking system of FIG. 4. A standard compressor structure with compression ratio of 2:1 to 3:1 can be appropriate (rather than the NAUC system described earlier), though some users may prefer other ratios, the NAUC system, or perhaps no compression. The choice of type of compression used can be made user selectable.

Variations on the approach shown in FIG. 4 are possible. Left and right earpiece microphone and audio signals can be acted on separately or combined and the monaural component processed to determine the gain to apply to the audio. Multiple BPF pass-bands could be set and the envelope detection and correlation done in parallel on the different bands, with the resulting correlation factors combined in a weighted fashion prior to comparison with a target. If random or natural sounds are desired as the masking signal rather than music, these could be stored in some compressed form in the system so that auto-masking can be accomplished without the need to connect to an audio source.

The embodiment described above determines the audio and microphone envelopes (time-varying levels) from an energy calculation by low-pass filtering with 10 ms time constant the square of the filtered signal level. Alternatively, the absolute value of the filter output can be low-pass filtered to determine an envelope. Also, other low-pass filter time constants than 10 ms may be used.

Other correlation block lengths than 200 ms may be used. Alternatively, the correlation may use a non-rectangular (weighted) window.

The embodiment above adjusts the volume level of the audio to maintain a target correlation value between the band-limited signal envelopes of the audio input and monitored microphone signal. Alternatively, the auto-masking system could be designed to adjust the volume level to maintain a target SNSR or SNR value.

The embodiment described above implements the auto-masking system for use with headphones. Alternatively, auto-masking could be implemented in other situations, for example in situations that are characterized by an approximately known time delay for propagation of output audio signal 125, through an acoustic environment, to microphone signal 119 and an acoustic environment that is largely absent of reverberation. Under such conditions auto-masking could be made to operate advantageously in a small room.

### 4 Noise reduction (FIG. 5)

The noise reduction module 126 is applied to the audio signal 125, which has already been subject to gain control and/or compression. Referring to FIG. 5, the noise canceller makes use of a negative feedback arrangement in which the microphone input 119 is fed back and compared to a desired audio signal, and the difference is fed forward to the audio driver. This arrangement is similar to that taught in U.S. Pat. 4,455,675, issued to Bose and Carter. In FIG. 5, the feedback loop includes control rules 520, which provide gain and frequency-dependent transfer function to be applied to the electrical signal. The output 127 of the control rules 520 is applied to the driver 116 in the earpiece. The driver has a frequency-dependent transfer function D between its electrical input 127 and the sound pressure 525 achieved in the earpiece. The microphone 118 senses the sound pressure and produces the electrical microphone input 119. The microphone has a transfer function M between the sound pressure 526 and the resulting electrical microphone signal 119. A preemphasis component 518 receives the output 125 from the masking module 124 and passes its output to the feedback loop. The preemphasis component 518 compensates for nonuniform frequency response characteristics introduced by the feedback loop.

Based on this arrangement, the audio signal applied to the noise canceller has an overall transfer function of

$$\left( \frac{ECD}{1+CMD} \right)$$

while the ambient noise has a transfer function

$$\left( \frac{1}{1+CMD} \right)$$

thereby attenuating the ambient noise beyond that which is achieved by the physical characteristics of the earpiece.

5 Implementation

The approaches described above are implemented using analog circuitry, digital circuitry or a combination of the two. Digital circuitry can include a digital signal processor that implements one or more of the signal processing steps described above. In the case of an implementation using digital signal processing, additional steps of anti-alias filtering and digitization and digital-to-analog conversion are not shown in the diagrams or discussed above, but are applied in a conventional manner. The analog circuitry can include elements such as discrete components, integrated circuits such as operational amplifiers, or large-scale analog integrated circuits.

The signal processor can be integrated into the headphone unit, or alternatively, all or part of the processing described above is housed in separate units, or housed in conjunction with the audio source. An audio source for noise masking can be integrated into the headphone unit thereby avoiding the need to provide an external audio source.

In implementations that make use of programmable processors, such as digital signal processors or general purpose microprocessor, the system includes a storage, such as a non-volatile semiconductor memory (e.g., "flash" memory) that holds instructions that when executed on the processor implement one or more of the modules of the system. In implementations in which an audio source is integrated with the headphone unit, such storage may also hold a digitized version of the audio signal input, or may hold instructions for synthesizing such an audio signal.

6 Alternatives

The discussion above concentrates on processing of a single channel. For stereo processing (i.e., two channels, one associated with each ear), one approach is to use a separate instance of signal processors for each ear/channel. Alternatively, some or all of the processing is shared for the two channels. For example, the audio inputs and microphone inputs may be summed for the two channels and a common gain is then applied to both the right and the left audio inputs. Some of the processing steps may be shared between the channels while others are done separately. In the present embodiment the compression and masking stages are performed on a monaural channel while the active noise reduction is performed separately for each channel.

Although aspects of the system, including both upward compression (NAUC) and auto-masking, are described above in the context of driving headphones, the approaches can be applied in other environments. Preferably, such other environments are ones in which (a) the microphone can sense what is being heard at the ear of users, (b) time delays in propagation of audio from speakers to the microphone are small compared to envelope detector time constants and (c) there is little reverberation. Examples of other applications besides headphones where the approaches can be applied are telephones (fixed or mobile), automobiles or aircraft cockpits, hearing aids, and small rooms.

It is to be understood that the foregoing description is intended to illustrate and not to limit the scope of the invention, which is defined by the scope of the appended claims. Other embodiments are within the scope of the following claims.

**Claims**

1. An audio processing system (100) comprising:

   an input for receiving an audio signal (131);
   a microphone (118) for monitoring an acoustic signal, the acoustic signal including components of an interfering signal (140) and the audio signal (131);
   a compressor circuit (324) for compressing the audio signal at a first compression ratio (235) when the audio signal is at a first level determined from the monitored acoustic signal and compressing the audio signal at a second compression ratio when the audio signal is above a second level determined from the monitored acoustic signal, the first level being lower than the second level and the first compression ratio being at least three times greater than the second compression ratio;

   **characterised by**
   a tracking circuit (322) configured to produce an estimate (SNSR, 321) of a ratio of a level of the audio signal to a level of the acoustic signal; and
   wherein the compressor circuit is arranged to calculate the compression ratios from said estimate produced by the tracking circuit, thereby avoiding separating the components of the audio signal and the interfering signal.

2. The audio processing system (100) of claim 1, wherein the compressor circuit (324) is configured to reduce a masking effect related to the interfering signal (140).

**3.** The audio processing system (100) of claim 2, wherein reducing the masking effect related to the interfering signal (140) comprises at least one of reducing an intelligibility of the interfering signal, reducing a distraction by the interfering signal, and masking the interfering signal.

**4.** The audio processing system (100) of claim 1, wherein the second level is greater than the first level.

**5.** The audio processing system (100) of claim 1, further comprising:

a masking module (124) that receives the audio signal (131) and the acoustic signal, the masking module including circuitry for processing the audio signal according to a level of the acoustic signal, including controlling a level of the audio signal input to reduce a masking effect of an interfering signal present in the acoustic signal.

**6.** The audio processing system (100) of claim 5, further comprising a selector to selectively enable at least one of the compression circuit and the masking module.

**7.** The audio processing system (100) of claim 1, comprising:

a correlator (420) for processing the audio signal according to a level of the microphone signal and a level of a modified audio signal (131), a level of the modified audio signal being controlled to reduce a distracting effect of the interfering signal; and
a bandpass filter (416) that filters the microphone signal and a bandpass filter that filters the modified audio signal (412).

**8.** The audio processing system (100) of claim 7, further comprising a control circuit (422,424) that controls the level of the modified audio signal.

**9.** The audio processing system (100) of claim 8, wherein the control circuit (422,424) controls the level of the modified audio signal such that an output of the correlator (420) is equal to or greater than a threshold value.

**10.** The audio processing system (100) of claim 8, wherein the control circuit comprises an integrator (424), an output of the integrator being responsive to an output of the correlator (420) and an output of a user controllable correlation target.

**11.** The audio processing system (100) of claim 1, further comprising an earpiece (112), headphone (110) or headset comprising a driver, wherein at least one of the tracking circuit (322) and the compressor circuit (324) is at least partially contained within the earpiece, headphone or headset.


**Patentansprüche**

**1.** Audioverarbeitungssystem (100), das Folgendes umfasst:

einen Eingang zum Empfangen eines Audiosignals (131);
ein Mikrofon (118) zum Überwachen eines akustischen Signals, wobei das akustische Signal Komponenten eines Störsignals (140) und das Audiosignal (131) aufweist;
eine Kompressorschaltung (324) zum Komprimieren des Audiosignals mit einer ersten Kompressionsrate (235), wenn sich das Audiosignal an einem ersten Pegel befindet, der aus dem überwachten akustischen Signal bestimmt wird, und Komprimieren des Audiosignals mit einer zweiten Kompressionsrate, wenn das Audiosignal oberhalb eines zweiten Pegels liegt, der aus dem überwachten akustischen Signal bestimmt wird, wobei der erste Pegel niedriger ist als der zweite Pegel und die erste Kompressionsrate mindestens dreimal größer ist als die zweite Kompressionsrate;

**gekennzeichnet durch**
eine Mitverfolgungsschaltung (322), die konfiguriert ist, um eine Schätzung (SNSR, 321) eines Verhältnisses eines Pegels des Audiosignals zu einem Pegel des akustischen Signals zu erzeugen; und
wobei die Kompressorschaltung eingerichtet ist, um die Kompressionsraten aus der Schätzung zu berechnen, die von der Mitverfolgungsschaltung erzeugt wird, wodurch das Trennen der Komponenten des Audiosignals und des Störsignals vermieden wird.

**2.** Audioverarbeitungssystem (100) nach Anspruch 1, wobei die Kompressorschaltung (324) konfiguriert ist, um einen Maskierungseffekt, der mit dem Störsignal (140) zusammenhängt, zu verringern.

**3.** Audioverarbeitungssystem (100) nach Anspruch 2, wobei das Verringern des Maskierungseffekts, der mit dem Störsignal (140) zusammenhängt, das Verringern einer Verständlichkeit des Störsignals und/oder das Verringern einer Distraktion durch das Störsignal und/oder das Maskieren des Störsignals umfasst.

**4.** Audioverarbeitungssystem (100) nach Anspruch 1, wobei der zweite Pegel größer ist als der erste Pegel.

**5.** Audioverarbeitungssystem (100) nach Anspruch 1, das ferner Folgendes umfasst:

ein Maskierungsmodul (124), das das Audiosignal (131) und das akustische Signal empfängt, wobei das Maskierungsmodul Schaltungen zum Verarbeiten des Audiosignals gemäß dem Pegel des akustischen Signals umfasst, darunter das Kontrollieren eines Pegels des Audiosignaleingangs, um einen Maskierungseffekt eines Störsignals, das in dem akustischen Signal vorhanden ist, zu verringern.

**6.** Audioverarbeitungssystem (100) nach Anspruch 5, das ferner einen Selektor zum selektiven Aktivieren der Kompressorschaltung und/oder des Maskierungsmoduls umfasst.

**7.** Audioverarbeitungssystem (100) nach Anspruch 1, das Folgendes umfasst:

einen Korrelator (420) zum Verarbeiten des Audiosignals gemäß einem Pegel des Mikrofonsignals und einem Pegel eines modifizierten Audiosignals (131), wobei ein Pegel des modifizierten Audiosignals gesteuert wird, um einen Distraktionseffekt des Störsignals zu verringern; und
ein Bandpassfilter (416), das das Mikrofonsignal filtert, und ein Bandpassfilter, das das modifizierte Audiosignal (412) filtert.

**8.** Audioverarbeitungssystem (100) nach Anspruch 7, das ferner eine Steuerschaltung (422, 424) umfasst, die den Pegel des modifizierten Audiosignals steuert.

**9.** Audioverarbeitungssystem (100) nach Anspruch 8, wobei die Steuerschaltung (422, 424) den Pegel des modifizierten Audiosignals derart steuert, dass ein Ausgang des Korrelators (420) gleich oder größer ist als ein Schwellenwert.

**10.** Audioverarbeitungssystem (100) nach Anspruch 8, wobei die Steuerschaltung einen Integrator (424), einen Ausgang des Integrators, der auf einen Ausgang des Korrelators (420) reagiert, und einen Ausgang eines vom Benutzer steuerbaren Korrelationsziels umfasst.

**11.** Audioverarbeitungssystem (100) nach Anspruch 1, das ferner einen Ohrhörer (112), Kopfhörer (110) oder ein Headset umfasst, das einen Treiber umfasst, wobei die Mitverfolgungsschaltung (322) und/oder die Kompressorschaltung (324) mindestens teilweise innerhalb des Ohrhörers, Kopfhörers oder Headsets enthalten ist.

**Revendications**

**1.** Système de traitement audio (100) comprenant :

une entrée pour recevoir un signal audio (131) ;
un microphone (118) pour surveiller un signal acoustique, le signal acoustique comprenant des composantes d'un signal d'interférence (140) et du signal audio (131) ;
un circuit compresseur (324) pour compresser le signal audio à un premier taux de compression (235) lorsque le signal audio est à un premier niveau déterminé à partir du signal acoustique surveillé et compresser le signal audio à un deuxième taux de compression lorsque le signal audio est au-dessus d'un deuxième niveau déterminé à partir du signal acoustique surveillé, le premier niveau étant inférieur au deuxième niveau et le premier taux de compression étant au moins trois fois supérieur au deuxième taux de compression ;

**caractérisé par**
un circuit de suivi (322) configuré pour produire une estimation (SNSR, 321) d'un rapport d'un niveau du signal audio sur un niveau du signal acoustique ; et

dans lequel le circuit compresseur est agencé pour calculer les taux de compression à partir de ladite estimation produite par le circuit de suivi, en évitant ainsi la séparation des composantes du signal audio et du signal d'interférence.

2. Système de traitement audio (100) selon la revendication 1, dans lequel le circuit compresseur (324) est configuré pour réduire un effet de masquage relatif au signal d'interférence (140).

3. Système de traitement audio (100) selon la revendication 2, dans lequel la réduction de l'effet de masquage relatif au signal d'interférence (140) comprend au moins l'un de la réduction d'une intelligibilité du signal d'interférence, la réduction d'une distraction par le signal d'interférence, et le masquage du signal d'interférence.

4. Système de traitement audio (100) selon la revendication 1, dans lequel le deuxième niveau est supérieur au premier niveau.

5. Système de traitement audio (100) selon la revendication 1, comprenant en outre :

un module de masquage (124) qui reçoit le signal audio (131) et le signal acoustique, le module de masquage comprenant une circuiterie pour traiter le signal audio en fonction d'un niveau du signal acoustique, comprenant la régulation d'un niveau du signal audio entré pour réduire un effet de masquage d'un signal d'interférence présent dans le signal acoustique.

6. Système de traitement audio (100) selon la revendication 5, comprenant en outre un sélecteur pour activer sélectivement au moins l'un du circuit de compression et du module de masquage.

7. Système de traitement audio (100) selon la revendication 1, comprenant :

un corrélateur (420) pour traiter le signal audio en fonction d'un niveau du signal de microphone et d'un niveau d'un signal audio (131) modifié, un niveau du signal audio modifié étant régulé pour réduire un effet de distraction du signal d'interférences ; et
un filtre passe-bande (416) qui filtre le signal de microphone et un filtre passe-bande qui filtre le signal audio modifié (412).

8. Système de traitement audio (100) selon la revendication 7, comprenant en outre un circuit de commande (422, 424) qui régule le niveau du signal audio modifié.

9. Système de traitement audio (100) selon la revendication 8, dans lequel le circuit de commande (422, 424) régule le niveau du signal audio modifié de sorte qu'une sortie du corrélateur (420) soit supérieure ou égale à une valeur de seuil.

10. Système de traitement audio (100) selon la revendication 8, dans lequel le circuit de commande comprend un intégrateur (424) dont une sortie répond à une sortie du corrélateur (420) et à une sortie d'une cible de corrélation réglable par l'utilisateur.

11. Système de traitement audio (100) selon la revendication 1, comprenant en outre une oreillette (112), un écouteur (110) ou un casque comprenant un circuit d'attaque, dans lequel au moins l'un du circuit de suivi (322) et du circuit compresseur (324) est au moins partiellement contenu à l'intérieur de l'oreillette, de l'écouteur ou du casque.

NOISE SOURCE 140

100

110

114

112

116

127

114

118 114

119

120

130 AUDIO SOURCE

132

VOLUME CONTROL

131

SIGNAL PROCESSOR 120

COMPRESSION MODULE 122

123

MASKING MODULE 124

125

NOISE REDUCTION MODULE 126

DRIVER OUTPUT SIGNAL 127

AUDIO SIGNAL INPUT 131

MICROPHONE INPUT 119

FIG. 1

FIG. 2A

FIG. 2B

FIG. 2C

FIG. 3

EP 1 889 258 B1

FIG. 4

EP 1 889 258 B1

FIG. 5

EP 1 889 258 B1

**EP 1 889 258 B1**

### Patent documents cited in the description

- US 5434922 A
- US 4891605 A
- US 4494074 A
- WO 0019686 A
- US 4455675 A